# EUROPÄISCHE PATENTSCHRIFT

(11) **EP 0 318 080 B1**
(45) Veröffentlichungstag und Bekanntmachung des Hinweises auf die Patenterteilung: **01.09.1993**
(21) Anmeldenummer: 88202542.2
(22) Anmeldetag: 15.11.1988
(51) Int. Cl.: G11C 7/00

(54) **Schaltungsanordnung für eine Doppel-Busleitung**
Circuit arrangement for a double bus
Circuit pour double bus

(30) Priorität: 21.11.1987 DE 3739467
(43) Veröffentlichungstag der Anmeldung: 31.05.1989
(73) Patentinhaber: Philips Electronics N.V., 5621 BA Eindhoven (NL)
(72) Erfinder: Pfennings, Leonardus Chritien Matheus Giellaumus, NL-5621 BA Eindhoven (NL); Voss, Peter Hermann, NL-5621 BA Eindhoven (NL); O'Connell, Cormac Michael, NL-5621 BA Eindhoven (NL); Phelan, Cathal Gerard, NL-5621 BA Eindhoven (NL); Davies, Thomas James, NL-5621 BA Eindhoven (NL); Ontrop, Hans,, NL-5621 BA Eindhoven (NL)
(74) Vertreter: Poddig, Dieter, Dipl.-Ing.

(56) Entgegenhaltungen:
- EP-A- 0 050 484
- EP-A- 0 214 787
- C.-H-. Col ema
- Wi-l-li am R.
- PATENT ABSTRACTS OF JAPAN, Band 3, Nr. 61 (E-113), 26. Mai 1979; & JP-A-54 41 027
- IBM TECHNICAL DISCLOSURE BULLETIN, Band 21, Nr. 3, August 1978, Seiten 1044-1048, New York, US; H.O. ASKIN et al.: "Off-chip driver"

## Beschreibung

Die Erfindung betrifft eine Schaltungsanordnung für eine Doppel-Busleitung zur Übertragung von Differenzsignalspannungen, von denen jede einzelne Busleitung mit einem anderen Eingang eines Differenzverstärkers verbunden ist, der mit einem ersten Pol und einem zweiten Pol einer Speisespannung verbunden ist und dessen Funktionsfähigkeit eingeschränkt ist, wenn die Differenzsignalspannung an beiden Eingängen in einem Tot-Spannungsbereich liegen, der von der Spannung am einen Pol der Speisespannung und von einer zwischen den Spannungen beider Pole liegenden Spannung begrenzt wird.

Doppel-Busleitungen zur Übertragung von Differenzsignalspannungen sind allgemein bekannt und werden verwendet, um die Störsicherheit der Signalspannungsübertragung zu erhöhen, denn ein Störsignal, das auf beide Busleitungen einwirkt, verändert allgemein die Signalspannungen auf beiden Busleitungen im wesentlichen in die gleiche Richtung und in gleichem Ausmaß, so daß die Differenz zwischen den Signalspannungen auf beiden Busleitungen im wesentlichen erhalten bleibt und die dadurch übertragene Information nicht verfälscht wird. In manchen Fällen können die Störsignale, die auf eine derartige Doppel-Busleitung einwirken, jedoch so groß sein, daß die Spannungen an beiden Eingängen des an die Doppel-Busleitung angeschlossenen Differenzverstärkers in den Tot-Spannungsbereich gelangen, in dem der Differenzverstärker nicht mehr ordnungsgemäß arbeitet. Der gleiche Effekt kann auch auftreten, wenn durch einen Störimpuls auf der Speisespannung des Differenzverstärkers dessen Tot-Spannungsbereich sich gegenüber den Signalspannungen auf der Doppel-Busleitung so verschiebt, daß diese beide in den Tot-Spannungsbereich gelangen. Dadurch kann der Differenzverstärker falsche Ausgangssignale erzeugen oder in seiner Ansprechgeschwindigkeit auf Anderungen der Signalspannungen auf der Doppel-Busleitung beeinträchtigt sein.

Aufgabe der Erfindung ist es daher, eine Schaltungsanordnung anzugeben, mit der weitgehend vermieden wird, daß die Signalspannungen auf der Doppel-Busleitung durch Störsignale in den Tot-Spannungsbereich des Differenzverstärkers gelangen.

Diese Aufgabe wird erfindungsgemäß dadurch gelöst, daß eine Einstellschaltung vorgesehen ist, die mit beiden Busleitungen verbunden ist und enthält
a) Detektormittel zum Erzeugen eines Steuersignals an einem Steuerausgang, wenn die Spannungen auf beiden Busleitungen gleichzeitig in dem Tot-Spannungsbereich liegen, und
b) eine Treiberschaltung, die mit beiden Busleitungen verbunden ist und auf das Steuersignal anspricht, um die Spannungen auf beiden Busleitungen um im wesentlichen dasselbe Ausmaß in Richtung auf die Spannung am anderen Pol zu verändern, bis die Spannung auf mindestens einer Busleitung außerhalb des Tot-Spannungsbereichs liegt.

Die erfindungsgemäße Einstellschaltung bewirkt also, daß bei einem Störsignal die Signalspannungen auf beiden Busleitungen im wesentlichen parallel so verändert werden, daß mindestens eine der Signalspannungen aus dem Tot-Spannungsbereich herauskommt. Dadurch wird die Information, die in der Differenz der Signalspannungen auf beiden Busleitungen enthalten ist, nicht wesentlich beeinträchtigt, so daß der Differenzverstärker stets ein dieser Differenz der Signalspannungen entsprechendes Ausgangssignal abgibt.

Die erfindungsgemäße Schaltungsanordnung kann bei Doppel-Busleitungen verwendet werden, die zum Beispiel als verdrillte Kabel ausgeführt sind und verschiedene Geräte oder Geräteteile miteinander verbinden. Eine Doppel-Busleitung zur Übertragung von Differenzsignalspannungen kann jedoch auch auf einer integrierten Schaltung angebracht sein. Die Erfindung bezieht sich daher auch auf eine integrierte Schaltung für die Verarbeitung digitaler Daten, insbesondere auf eine integrierte Speicheranordnung, mit der erfindungsgemäßen Schaltungsanordnung und ist dadurch gekennzeichnet, daß die Doppel-Busleitung eine Datenleitung ist, die über eine wesentliche räumliche Strecke innerhalb der integrierten Schaltungsanordnung zu einem den Differenzverstärker darstellenden Leseverstärker führt, wobei die Spannung auf beiden einzelnen Busleitungen über eine Vorladeschaltung zeitweise auf mindestens einen Wert in unmittelbarer Nähe der einen Grenze des Tot-Spannungsbereichs gebracht wird, wobei die Detektormittel und die Treiberschaltung in der räumlichen Nähe des Leseverstärkers angeordnet sind.

Bei einer integrierten Speicheranordnung für die Speicherung einer sehr großen Anzahl von Daten bzw. Bits können nämlich lange Leiterbahnen auftreten, über die die aus den Speicherzellen ausgelesenen Signale zu einem Leseverstärker übertragen werden, wobei diese ausgelesenen Signale häufig eine wesentlich kleinere Amplitude haben als die digitalen Signale, die von der integrierten Schaltung empfangen und abgegeben werden. Ferner sind die Signalquellen für die Lesesignale, das sind die Speicherzellen selbst oder über Vorverstärker davon abgeleitete Lesesignale, allgemein relativ hochohmig, so daß eine größere Pegelveränderung relativ langsam erfolgt, während eine kleine Differenzänderung, die bereits zur Ansteuerung des an die Doppel-Busleitung angeschlossenen Differenzverstärkers ausreicht, relativ schnell erfolgen kann. Die Vorladeschaltung dient dabei dazu, den mittleren Pegel beider Busleitungen etwa in den Spannungsbereich des optimalen Verhaltens des Differenzverstärkers zu bringen, der häufig in der Nähe des Tot-Spannungsbereichs liegt, aber diese Vorladeschaltung ist häufig so aufgebaut, daß sie nicht verhindern kann, daß insbesondere durch Störsignale die Spannungen auf beiden Busleitungen in den Tot-Spannungsbereich des Differenzverstärkers gelangen. Dies wird durch die erfindungsgemäße Schaltungsanordnung vermieden.

Integrierte Schaltungsanordnungen sind häufig in MOS-Technik aufgebaut. Hierfür ist eine weitere Ausgestaltung der Erfindung dadurch gekennzeichnet, daß die Detektormittel zwei erste Anreicherungs-MOS-Transistoren umfassen, die parallel zwischen dem einen Pol der Speisespannung und dem Steuerausgang geschaltet sind und deren Gates mit den Busleitungen verbunden sind, wobei der Steuerausgang über eine Widerstandsanordnung mit dem anderen Pol der Speisespannung verbunden ist, und daß die Treiberschaltung zwei zweite Anreicherungs-MOS-Transistoren entgegengesetzten Leitfähigkeitstyps wie die ersten Transistoren aufweist, die je zwischen einer Busleitung und dem anderen Pol der Speisespannung angeordnet sind und deren Gates durch das Steuersignal über eine MOS-Inverterschaltung gesteuert sind.

Weitere Ausgestaltungen der Erfindung sind in den übrigen Unteransprüchen gekennzeichnet.

Ausführungsbeispiele der Erfindung werden nachstehend anhand der Zeichnung näher erläutert. Es zeigen:
- Fig. 1: schematisch als Blockschaltbild eine Doppel-Busleitung nach der erfindungsgemäßen Schaltungsanordnung,
- Fig. 2a bis 2c: einige Diagramme für den zeitlichen Verlauf einiger Spannungen im Blockschaltbild nach Fig. 1,
- Fig. 3: eine Ausführung der Detektormittel und der Treiberschaltung mit MOS-Transistoren,
- Fig. 4: ein entsprechendes Schaltbild mit zusätzlichen Transistoren zur Verhinderung der Entstehung heißer Elektronen.

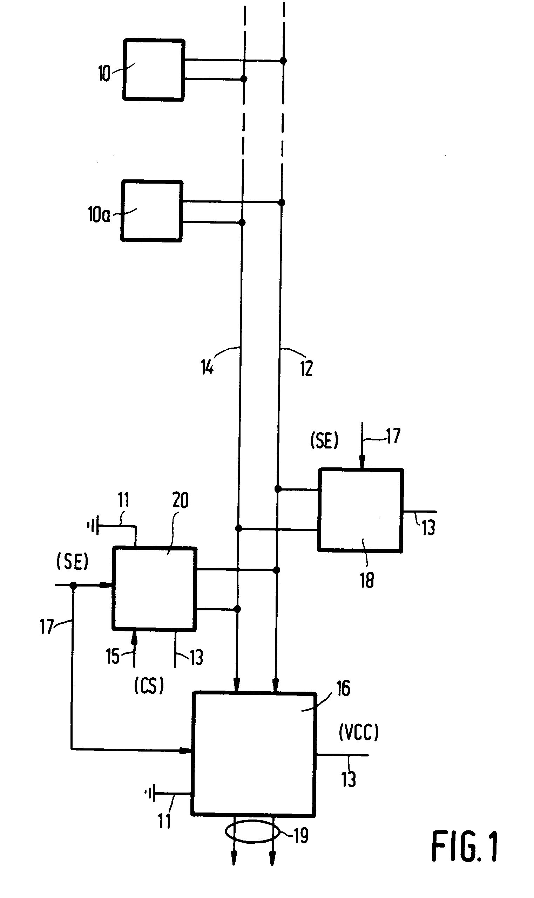

In Fig. 1 ist ein die Datenübertragung betreffender Teil eines integrierten Speichers dargestellt. Die beiden Busleitungen 12 und 14 bilden eine Doppel-Busleitung, die eine Anzahl Lese-Vorverstärker, von denen als Beispiel nur die Verstärker 10 und 10a angedeutet sind, mit einem Differenzverstärker 16 verbindet, der an seinem Ausgang 19 komplementäre Ausgangssignale abgibt, die beispielsweise einen nicht dargestellten Ausgangsverstärker steuern. Von den Lese-Vorverstärkern 10, 10a wird jeweils einer durch ein nicht dargestelltes Auswahlsignal aktiv geschaltet.

Mit den Bus-Leitungen 12 und 14 ist eine Vorladeschaltung 18 verbunden, die die Spannungen auf den beiden Busleitungen 12 und 14 auf einen Spannungspegel bringt, der in dem Eingangsspannungsbereich des Differenzverstärkers 16 für eine optimale Funktion liegt. Wenn der Differenzverstärker 16 als Eingangsstufe ein Transistorpaar enthält, beispielsweise p-leitende Anreicherungs-MOS-Transistoren, die mit dem positiven Pol einer Speisespannung 13 verbunden sind, müssen die Gate-Spannungen der Transistoren etwas negativer sein als die Speisespannung, damit die Transistoren ausreichend leitend sind, jedoch nicht zu negativ, um den maximalen Aussteuerungsbereich der Transistoren zu erhalten. Die Vorladeschaltung 18 bringt die Spannungen auf den Busleitungen 12 und 14 nun auf einen Wert, der innerhalb des vorstehend beschriebenen optimalen Eingangsspannungsbereichs des Differenzverstärkers 16 liegt, solange ein Signal SE an einem Steuereingang 17 der Vorladeschaltung 18 ein hohes Signal hat. Ferner wird während dieser Zeit durch einen nicht dargestellten Schalter zwischen den Busleitungen 12 und 14 deren Spannungen aneinander angeglichen, was jedoch für die Erfindung nicht weiter von Bedeutung ist.

Die Vorladeschaltung 18 ist nun so aufgebaut, daß die Spannungen auf den Busleitungen 12 und 14 während des hohen Signals SE einen Mindestwert einhalten, jedoch können die Spannungen auch unter bestimmten Umständen positiver werden, so daß sie dann den optimalen Eingangsspannungsbereich des Differenzverstärkers 16 verlassen und in einen Tot-Spannungsbereich gehen, bei dem die beispielsweise angenommenen Transistoren des Differenzverstärkers 16 beide gesperrt sind. Dabei werden dann am Ausgang 19 keine korrekten komplementären Signale abgegeben. Wenn durch einen ausgewählten Vorverstärker 10 bzw. 10a eine Spannungsdifferenz zwischen den Spannungen auf den Busleitungen 12 und 14 erzeugt wird, wobei dann die Vorladeschaltung 18 durch ein niedriges Signal SE abgeschaltet ist, gelangt auf einer der Busleitungen die Spannung zwar wieder in den optimalen Eingangsspannungsbereich des Differenzverstärkers 16, jedoch erfolgt dieser Vorgang langsam, da die Verstärker 10, 10a hochohmig sind und die unvermeidlichen Kapazitäten der Busleitungen 12 und 14 nicht beliebig schnell umladen können, so daß eine Verzögerung in der Signalauswertung auftritt.

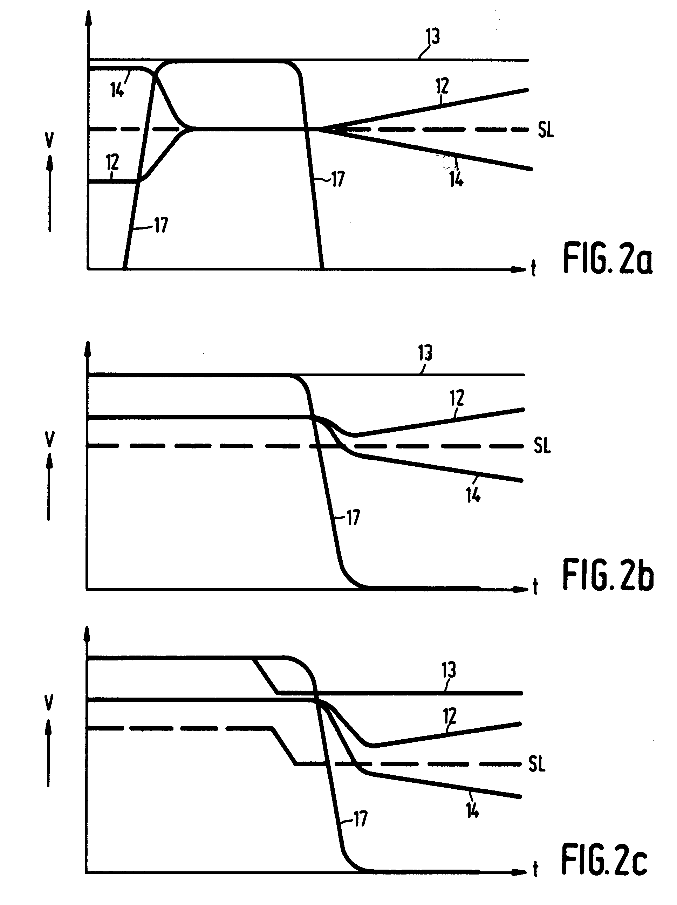

Um dies zu vermeiden, ist eine Einstellschaltung 20 vorgesehen, die ebenfalls mit beiden Busleitungen 12 und 14 verbunden ist und die ebenso wie der Differenzverstärker 16 an die beiden Pole 11 und 13 der Speisespannung angeschlossen ist. Ferner wird die Einstellschaltung 20 ebenso wie die Vorladeschaltung 18 durch das Signal SE auf der Leitung 17 angesteuert, wobei im übrigen auch der Differenzverstärker 16 von diesem Signal gesteuert wird. Die Steuerung erfolgt in der Weise, daß bei einem hohen Signal SE die Vorladeschaltung 18 aktiv und die Einstellschaltung 20 sowie der Differenzverstärker 16 inaktiv geschaltet sind, während bei einem niedrigen Signal SE die Vorladeschaltung 18 gesperrt und die Einstellschaltung 20 sowie der Differenzverstärker 16 eingeschaltet sind. Die Wirkungsweise der Einstellschaltung 20 soll anhand der in der Fig. 2 dargestellten Zeitdiagramme näher erläutert werden, wobei die Steuerung durch das Signal CS über die Leitung 15 zunächst außer acht gelassen wird.

In Fig. 2a ist angenommen, daß kurz aufeinanderfolgend zwei Speicherstellen angesteuert werden, wobei die ansteigende Flanke des Signals SE auf der Leitung 17 das Ende der Ansteuerung der einen Speicherstelle und die abfallende Flanke die Auswertung des Informationsinhalts der danach angesteuerten Speicherstelle angibt. Die dazwischen erforderlichen sonstigen Signalspannungsänderungen sind nicht dargestellt, da sie für die Erfindung nicht von Bedeutung sind.

Vor dem Ansteigen des Signals auf der Leitung 17 hatten die Busleitungen 12 und 14 ein Differenzsignal angenommen, das der Information der ausgelesenen Speicherstelle entsprach. Mit dem Ansteigen des Signals auf der Leitung 17 wird die Vorladeschaltung 18 angesteuert, die beide Bus leitungen durch den bereits erwähnten, nicht dargestellten Schalter kurzchließt, so daß die Spannungen auf beiden Busleitungen auf den den optimalen Eingangsspannungspegel des Differenzverstärkers 16 gehen, der hier mit SL angegeben ist. Dabei ist angenommen, daß die Spannungen beider Busleitungen symmetrisch zu diesem Pegel SL waren. Falls diese Spannungen sich unsymmetrisch verändert hatten und etwas niedriger geworden waren, werden sie durch die Vorladeschaltung wieder im wesentlichen auf den optimalen Eingangsspannungspegel SL gebracht. Sobald das Signal auf der Leitung 17 wieder niedrig wird, können die Spannungen auf den Busleitungen 12 und 14 sich infolge der Ansteuerung durch den ausgewählten Lese-Vorverstärker entsprechend der ausgelesenen Information ändern, wobei sich sehr schnell eine ausreichende Spannungsdifferenz ergibt, auf die der Differenzverstärker 16 anspricht.

In Fig. 2b ist nun angenommen, daß das letzte Auslesen einer Speicherstelle längere Zeit vorher stattgefunden hat, d.h. das Signal auf der Leitung 17 ist längere Zeit hoch, und die Spannungen auf den Busleitungen 12 und 14 sind beispielsweise durch Leckströme in einen Spannungsbereich zwischen dem optimalen Spannungspegel SL und der positiven Betriebsspannung 13 gedriftet, der im wesentlichen den Tot-Spannungsbereich des Differenzverstärkers 16 darstellt, da die Vorladeschaltung 18 lediglich dafür sorgt, daß die Spannungen auf den Busleitungen 12 und 14 nicht negativer werden als der optimale Eingangsspannungspegel SL des Differenzverstärkers 16. Wenn nun nach Auswahl einer Speicherstelle das Signal auf der Leitung 17 niedrig wird, bewirkt die Einstellschaltung 20, daß die Spannungen auf beiden Busleitungen 12 und 14 schnell in Richtung auf die Spannung am Pol 11 der Speisespannung, d.h. in Richtung Masse gezogen werden, und zwar beide um das gleiche Ausmaß. Aus Fig. 2b ist zu erkennen, daß dadurch die Spannung auf der Busleitung 14 schnell in den optimalen Eingangsspannungsbereich des Differenzverstärkers 16 gelangt, wobei die sich vergrößernde Differenzspannung auf beiden Busleitungen durch Ansteuerung vom ausgewählten Lese-Vorverstärker erzeugt wird, so daß trotz der vorher weggedrifteten Spannungen auf den Busleitungen 12 und 14 der Differenzverstärker 16 schnell ansprechen kann, nachdem er durch die abfallende Flanke des Signals auf der Leitung 17 eingeschaltet worden ist.

In Fig. 2c ist angenommen, daß die Spannung am positiven Pol 13 der Speisespannung einen zumindest kurzzeitigen Einbruch erleidet, beispielsweise hervorgerufen durch eine schnelle Stromänderung über den positiven Pol 13 der Speisespannung. In diesem Falle verschiebt sich der optimale Eingangsspannungspegel SL des Differenzverstärkers 16 ebenfalls um den gleichen Betrag, da, wie früher erwähnt, die Eingangsstufe des Differenzverstärkers 16 einen Mindest-Spannungsabstand am Eingang von der positiven Speisespannung 13 benötigt. Der Tot-Spannungsbereich des Differenzverstärkers 16 ist also um das Ausmaß des Spannungseinbruchs verschoben. Wenn in diesem Zustand das Signal auf der Leitung 17 niedrig wird, werden die Spannungen auf beiden Busleitungen 12 und 14 durch die Einstellschaltung 20 ebenfalls niedriger gemacht, bis mindestens eine dieser Spannungen unter den Spannungspegel SL kommt, d.h. im Beispiel nach Fig. 2c die Spannung auf der Busleitung 14. Danach ändern sich dann die Spannungen auf beiden Busleitungen 12 und 14, d.h. deren Differenz ändert sich weiter entsprechend der Ansteuerung durch den entsprechenden Vorverstärker, als wären beide Busspannungen bei der negativen Flanke des Signals auf der Leitung 17 von einem gemeinsamen Pegel entsprechend dem optimalen Eingangsspannungspegel SL ausgegangen. Auch hier ist zu erkennen, daß der Differenzverstärker 16 unmittelbar nach der negativen Flanke des Signals auf der Leitung 17 wieder korrekt arbeiten kann.

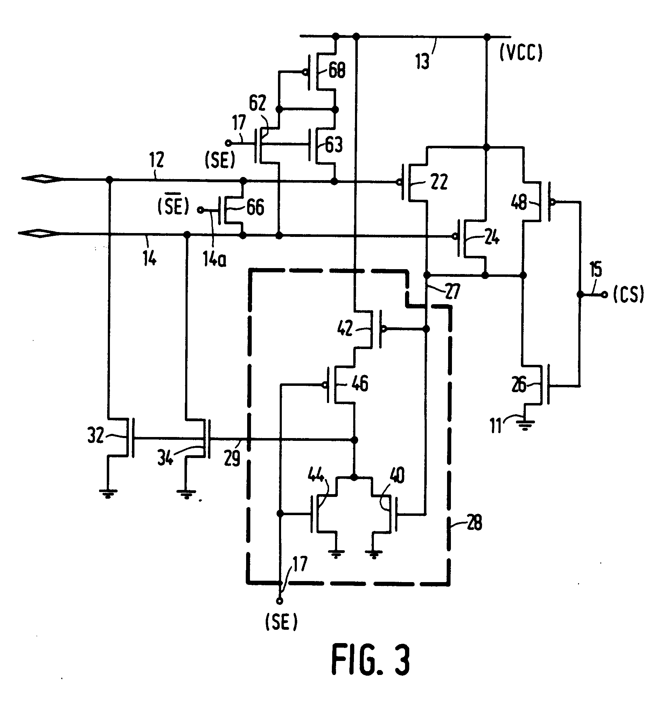

In Fig. 3 ist ein Ausführungsbeispiel der Einstellschaltung 20 mit Anreicherungs-MOS-Transistoren dargestellt, worin auch ein Teil der Vorladeschaltung 18 gezeigt ist.

Diese besteht im wesentlichen aus den NMOS-Transistoren 62 und 63, die jeweils eine der Busleitungen 12 und 14 über einen als Diode geschalteten Anreicherungs-PMOS-Transistor 68 mit dem positiven Pol 13 der Speisespannung verbinden, wenn das Signal SE auf der Leitung 17 hoch ist, d.h. im wesentlichen den gleichen Spannungswert hat wie der positive Pol 13 der Speisespannung. Ferner sind beide Busleitungen 12 und 14 durch einen PMOS-Transistor 66 verbunden, der durch das inverse Signal S̅E̅ auf der Leitung 14a angesteuert wird und leitend ist, wenn dieses Signal niedrig ist, d.h. das Signal SE auf der Leitung hoch ist. Die Schwellspannungen der Transistoren 62, 63 und 68 sind so gewählt, daß diese leitend werden, wenn die Spannung auf der betreffenden Busleitung 12 oder 14 negativer ist als der in Fig. 2 angedeutete optimale Spannungspegel SL. Die Spannung auf den Busleitungen 12 und 14 kann jedoch, beispielsweise durch ein entsprechendes kapazitiv eingestreutes Störsignal oder Leckströme oder einen Spannungseinbruch auf der positiven Speisespannung 13, höher werden als der optimale Spannungspegel SL.

Um dies zu verhindern, ist die Einstellschaltung vorgesehen, die hier im wesentlichen aus den PMOS-Transistoren 22 und 24 sowie den NMOS-Transistoren 26, 32 und 34 sowie dem Inverter 28 besteht. Dabei wird angenommen, daß das Signal CS auf der Leitung 15 hoch ist, so daß der Transistor 26 eingeschaltet ist. Wenn die Spannung auf mindestens einer der Busleitungen 12 oder 14 genügend niedrig ist, ist mindestens einer der Transistoren 22 oder 24 leitend. Wenn das Verhältnis der Länge zur Breite des Kanals jedes der Transistoren 22 und 24 wesentlich größer gewählt wird als das entsprechende Verhältnis des Transistors 26, kann erreicht werden, daß die Verbindung 27 aller drei Transistoren eine hohe Signalspannung führt, wenn die Spannungen auf mindestens einer der Busleitungen 12 bzw. 14 im wesentlichen auf den optimalen Spannungspegel SL liegt. Wenn beide Spannungen höher sind, werden die Transistoren 22 und 24 so weit gesperrt, daß das Signal auf der Leitung 27 durch den Transistor 26 nach niedrig in Richtung auf den Massepol 11 der Speisespannung gezogen wird, so daß die Leitung 29 am Ausgang des Inverters 28 positiv wird und die beiden Transistoren 32 und 34 einschaltet. Diese Transistoren verbinden dann die Busleitung 12 bzw. 14 mit dem Massepotential 11, so daß die Spannung auf beiden Busleitungen niedriger gemacht wird, bis die Spannung auf mindestens einer der Busleitungen den Spannungspegel SL unterschreitet und den entsprechenden Transistor 22 oder 24 so leitend macht, daß die Spannung auf der Verbindung 27 wieder hoch geht.

Der Inverter 28 ist als invertierendes CMOS-Gatter ausgeführt, das die mit der positiven Speisespannung 13 verbundene Reihenschaltung der beiden PMOS-Transistoren 42 und 46 und die mit Massepotential 11 verbundene Parallelschaltung der beiden NMOS-Transistoren 40 und 44 umfaßt, deren Verbindungspunkt an die Ausgangsleitung 29 des Inverters 28 angeschlossen ist. Die Gates der Transistoren 44 und 46 sind mit der Leitung 17 verbunden, die das Signal SE führt. Wenn dieses Signal hoch ist, ist der Transistor 44 leitend und der Transistor 46 gesperrt, so daß das Signal auf der Ausgangsleitung 29 niedrig ist und die Transistoren 32 und 34 gesperrt sind, unabhängig vom Signalzustand auf der Leitung 27. Nur wenn das Signal SE niedrig ist, ist der Transistor 44 gesperrt und der Transistor 46 leitend, und damit tritt dann auf der Ausgangsleitung 29 das inverse Signal wie auf der Leitung 27 auf. Dies entspricht den anhand der Fig. 2a bis 2c erläuterten Verhältnissen.

Parallel zu den Transistoren 22 und 24 liegt ein weiterer PMOS-Transistor 48, dessen Gate ebenso wie das des Transistors 26 mit der Leitung 15 verbunden ist, die ein Detektorausschaltsignal CS führt. Wenn dieses Signal niedrig ist, ist der Transistor 26 gesperrt und der Transistor 48 leitend, wodurch der Detektor ausgeschaltet und damit verhindert wird, daß ein ständiger Strom zwischen beiden Polen der Speisespannung fließt. Durch das niedrige Signal CS in bestimmten Phasen der Ansteuerung der integrierten Speicheranordnung kann dadurch Verlustleistung vermieden werden.

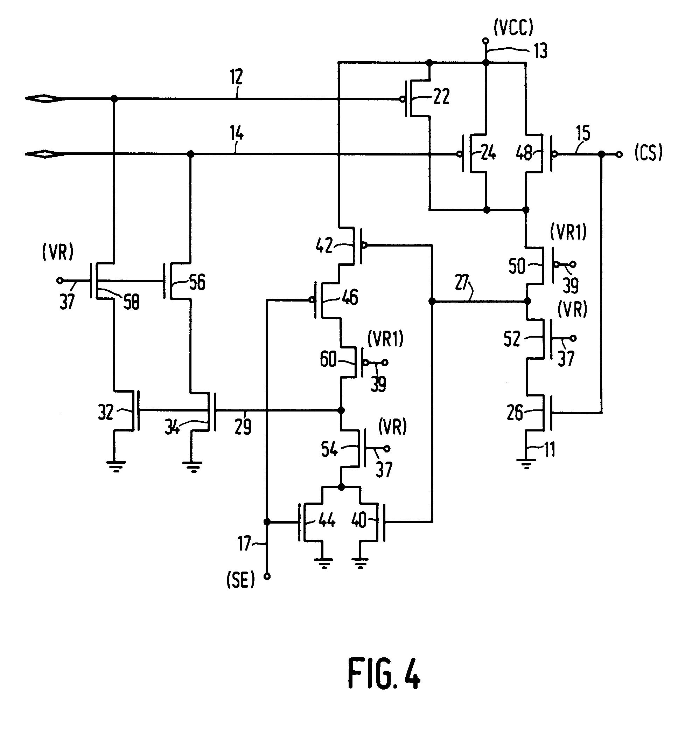

Die Schaltung nach Fig. 4 unterscheidet sich von der nach Fig. 3 darin, daß die Vorladeschaltung mit den Transistoren 62, 63, 66 und 68 weggelassen ist und daß in Reihe mit den Transistoren 26, 32 und 34 sowie der Parallelschaltung der Transistoren 40 und 44 je ein NMOS-Transistor 52, 58, 56 bzw. 54 geschaltet ist, deren Gates mit einer Leitung 37 verbunden sind, die eine Vorspannung VR gleich einem Bruchteil der Speisespannung führt. In entsprechender Weise ist in Reihe mit der Parallelschaltung 22, 24 und 48 und der Reihenschaltung der Transistoren 42 und 46 je ein weiterer PMOS-Transistor 50 bzw. 60 geschaltet, deren Gates mit einer Leitung 39 verbunden ist, die eine Vorspannung VR1 gleich einem Bruchteil der Speisespannung führt, wobei die beiden Bruchteile normalerweise unterschiedlich sind. Im einfachsten Fall kann VR auch gleich VCC und VR1 gleich Masse gewählt werden. Diese zusätzlichen Transistoren verhindern das Auftreten von heißen Elektronen in bestimmten Bereichen der entsprechenden Transistoren, mit denen sie in Reihe geschaltet sind.

Es ist klar, daß die in Fig. 3 bzw. Fig. 4 dargestellte Schaltung in unmittelbarer räumlicher Nähe des Differenzverstärkers 16 angeordnet werden muß, damit zwischen den Anschlüssen an die gleichnamigen Pole 11 bzw. 13 der Speisespannung keine wesentlichen Spannungsunterschiede auftreten können.

Die vorstehend erläuterten Ausführungsbeispiele der Erfindung beziehen sich auf eine integrierte Schaltung, jedoch ist es klar, daß die Doppel-Busleitung aus den einzelnen Busleitungen 12 und 14 auch verschiedene Geräte bzw. Geräteteile verbinden kann und daß die Einstellschaltung auch in anderer Weise als in Fig. 3 und Fig. 4 dargestellt realisiert werden kann, insbesondere auch mit diskreten Bauelementen.

## Patentansprüche

1. Schaltungsanordnung für eine Doppel-Busleitung zur Übertragung von Differenzsignalspannungen, von denen jede einzelne Busleitung (12,14) mit einem anderen Eingang eines Differenzverstärkers (16) verbunden ist, der mit einem ersten Pol (13) und einem zweiten Pol (11) einer Speisespannung verbunden ist und dessen Funktionsfähigkeit eingeschränkt ist, wenn die Differenzsignalspannungen an beiden Eingängen in einem Tot-Spannungsbereich liegen, der von der Spannung am einen Pol (13) der Speisespannung und von einer zwischen den Spannungen beider Pole liegenden Spannung begrenzt wird,
dadurch gekennzeichnet, daß eine Einstellschaltung (20) vorgesehen ist, die mit beiden Busleitungen (12, 14) verbunden ist und enthält
a) Detektormittel (22, 24, 26) zum Erzeugen eines Steuersignals an einem Steuerausgang (27), wenn die Spannungen auf beiden Busleitungen gleichzeitig in dem Tot-Spannungsbereich liegen, und
b) eine Treiberschaltung (32, 34), die mit beiden Busleitungen verbunden ist und auf das Steuersignal anspricht, um die Spannungen auf beiden Busleitungen um im wesentlichen dasselbe Ausmaß in Richtung auf die Spannung am anderen Pol (11) zu verändern, bis die Spannung auf mindestens einer Busleitung außerhalb des Tot-Spannungsbereichs liegt.

2. Integrierte Schaltungsanordnung für die Verarbeitung digitaler Daten, insbesondere integrierte Speicheranordnung, mit einer Schaltungsanordnung nach Anspruch 1,
dadurch gekennzeichnet, daß die Doppel-Busleitung (12, 14) eine Datenleitung ist, die über eine wesentliche räumliche Strecke innerhalb der integrierten Schaltungsanordnung zu einem den Differenzverstärker darstellenden Leseverstärker (16) führt, wobei die Spannung auf beiden einzelnen Busleitungen (12, 14) über eine Vorladeschaltung (18) zeitweise auf mindestens einen Wert in unmittelbarer Nähe der einen Grenze des Tot-Spannungsbereichs gebracht wird, wobei die Detektormittel (22, 24, 26) und die Treiberschaltung (32, 34) in der räumlichen Nähe des Leseverstärkers (16) angeordnet sind.

3. Integrierte Schaltung nach Anspruch 2,
dadurch gekennzeichnet, daß die Detektormittel zwei erste Anreicherungs-MOS-Transistoren (22, 24) umfassen, die parallel zwischen dem einen Pol (13) der Speisespannung und dem Steuerausgang (27) geschaltet sind und deren Gates mit den Busleitungen (12, 14) verbunden sind, wobei der Steuerausgang über eine Widerstandsanordnung (26) mit dem anderen Pol (11) der Speisespannung verbunden ist, und daß die Treiberschaltung zwei zweite Anreicherungs-MOS-Transistoren (32, 34) entgegengesetzten Leitfähigkeitstyps wie die ersten Transistoren (22, 24) aufweist, die je zwischen einer Busleitung (12, 14) und dem anderen Pol (11) der Speisespannung angeordnet sind und deren Gates durch das Steuersignal über eine MOS-Inverterschaltung gesteuert sind.

4. Integrierte Schaltung nach Anspruch 3,
dadurch gekennzeichnet, daß die Inverterschaltung (28) als invertierendes CMOS-Gatter (40, 42, 44, 46) mit einem Schalteingang (17) aufgebaut ist, daß der Differenzverstärker (16) einen Schalteingang (17) zum Unwirksamschalten aufweist und daß beide Schalteingänge von einem gemeinsamen Schaltsignal (SE) angesteuert sind.

5. Integrierte Schaltung nach Anspruch 3 oder 4,
dadurch gekennzeichnet, daß die Widerstandsanordnung ein dritter Anreicherungs-MOS-Transistor (26) gleichen Leitfähigkeitstyps wie die zweiten Transistoren (32, 34) ist, dessen Breiten-Längenverhältnis kleiner als das der ersten Transistoren (22, 24) ist, daß parallel zu den ersten Transistoren (22, 24) ein vierter Anreicherungs-MOS-Transistor (48) gleichen Leitfähigkeitstyps wie diese angeordnet ist und die Gates des dritten und vierten Transistors durch ein Detektorschaltsignal (CS) gesteuert sind.

6. Integrierte Schaltung nach einem der Ansprüche 3 bis 5 mit einer solch kleinen Struktur, daß dabei in zumindest einigen Transistoren heiße Elektronen auftreten können,
dadurch gekennzeichnet, daß zwischen mindestens einem Teil der mit den Polen (11, 13) der Speisespannung verbundenen Transistoren (22, 24, 48; 26, 32, 34, 40, 44) und den zugehörigen Signalausgängen dieser Transistoren je ein weiterer Transistor (50; 52, 54, 56, 58) von jeweils gleichem Leitfähigkeitstyp angeordnet ist, dessen Gate mit einer festen Vorspannung (VR, VR1) verbunden ist.

## Claims

1. A circuit arrangement for a dual bus line for the transmission of differential signal voltages, each individual bus line (12, 14) of which is connected to a different input of a differential amplifier (16) which is connected to a first pole (13) and a second pole (11) of a supply voltage and whose operativeness is restricted if the differential signal voltages at the two inputs are within a dead voltage range which is bounded by the voltage at one pole of the supply voltage and by a voltage between the voltages of the two poles, characterized in that there is provided an adjusting circuit (20) which is connected to both bus lines (12, 14) and comprises
a) detector means (22, 24, 26) for generating a control signal at a control output (27) if the voltages on both bus lines are simultaneously within the dead voltage range, and
b) a driver circuit (32, 34) which is connected to both bus lines and responds to the control signal in order to change the voltages on both bus lines by essentially the same amount in the direction of the voltage at the other pole (11) until the voltage on at least one bus line is outside the dead voltage range.

2. An integrated circuit arrangement for processing digital data, notably an integrated memory arrangement, comprising a circuit arrangement as claimed in Claim 1, characterized in that the dual bus line (12, 14) is a data line which leads, over an essentially spatial extent within the integrated circuit arrangement, to a read amplifier (16) which represents the differential amplifier, the voltage on both individual bus lines (12, 14) being temporarily adjusted to at least a value in the immediate vicinity of one boundary of the dead voltage range via a precharge circuit (18), the detector means (22, 24, 26) and the driver circuit (32, 34) being arranged in the spatial vicinity of the read amplifier (16).

3. An integrated circuit as claimed in Claim 2, characterized in that the detector means comprise two first enhancement-type MOS transistors (22, 24) which are connected in parallel between one pole (13) of the supply voltage and the control output (27) and whose gates are connected to the bus lines (12, 14), the control output being connected to the other pole (11) of the supply voltage via a resistor arrangement (26), and that the driver circuit comprises two second enhancement-type MOS transistors (32, 34) of the opposite type of conductivity relative to the first transistors (22, 24), each of the second transistors being arranged between a respective bus line (12, 14) and the other pole (11) of the supply voltage and their gates being controlled by the control signal via a MOS inverter circuit.

4. An integrated circuit as claimed in Claim 3, characterized in that the inverter circuit (28) is constructed as an inverting CMOS gate (40, 42, 44, 46) having a switching input (17), the differential amplifier (16) comprising a disable switching input (17) and both switching inputs being controlled by a common switching signal (SE).

5. An integrated circuit as claimed in Claim 3 or 4, characterized in that the resistance arrangement is a third enhancement-type MOS transistor (26) of the same conductivity type as the second transistors (32, 34), its width/length ratio being smaller than that of the first transistors (22, 24), that a fourth enhancement-type MOS transistor (48) of the same conductivity type as the first transistors (22, 24) is arranged in parallel therewith and that the gates of the third and the fourth transistor are controlled by a detector switching signal (CS).

6. An integrated circuit as claimed in one of the Claims 3 to 5, having such a small structure that hot electrons can occur in at least some transistors, characterized in that between at least some of the transistors (22, 24, 48; 26, 32, 34, 40, 44) connected to the poles (11, 13) of the supply voltage and the associated signal outputs of these transistors a respective further transistor (50; 52, 54, 56, 58) of the respective same conductivity type is arranged whose gate is connected to a fixed bias voltage (VR, VR1).

## Revendications

1. Montage de circuit pour un double bus destiné à la transmission de tensions de signalisation différentielles, chaque bus individuel (12, 14) étant connecté à une autre entrée d'un amplifieateur différentiel (16) qui est connecté à un premier pôle (13) et à un second pôle (11) d'une tension d'alimentation et dont la fonctionnalité est restreinte lorsque les tensions de signalisation différentielles aux deux entrées se trouvent dans un domaine de tensions mort qui est limité par la tension sur le premier pôle (13) de la tension d'alimentation et par une tension qui se situe entre les tensions des deux pôles, caractérisé en ce qu'il est prévu un circuit de réglage (20) qui est raccordé aux deux bus (12, 14) et comporte :
a) des moyens de détection (22, 24, 26) pour produire un signal de commande sur une sortie de commande (27) lorsque les tensions sur les deux bus se trouvent simultanément dans le domaine de tensions mort, et
b) un circuit d'attaque (32, 34), qui est connecté aux deux bus et répond au signal de commande pour modifier les tensions sur les deux bus sensiblement dans la même mesure et dans le sens de la tension à l'autre pôle (11) jusqu'à ce que la tension sur au moins un bus se trouve hors du domaine de tensions mort.

2. Montage de circuit intégré pour le traitement de données numériques, en particulier, un montage à mémoire intégré, avec un montage de circuit selon la revendication 1, caractérisé en ce que le double bus (12, 14) est une ligne de transmission de données qui mène, via un trajet essentiellement spatial au sein du montage de circuit intégré, à un amplificateur de lecture (16) représentant l'ampliflcateur différentiel, la tension sur les deux bus (12, 14) individuels étant amenée temporairement via un circuit de préchargement (18) à au moins une valeur qui se trouve au voisinage direct de la première limite du domaine de tensions mort, tandis que les moyens de détection (22, 24, 26) et le circuit d'attaque (32, 34) sont agencés au voisinage spatial de l'ampliflcateur de lecture (16).

3. Circuit intégré selon la revendication 2, caractérisé en ce que les moyens de détection comprennent deux premiers transistors MOS du type à enrichissement (22, 24) qui sont branchés en parallèle entre le premier pôle (13) de la tension d'alimentation et la sortie de commande (27) et dont les grilles sont connectées aux bus (12, 14), la sortie de commande étant connectée via un montage à résistance (26) à l'autre pôle (11) de la tension d'alimentation, et le circuit d'attaque comporte deux seconds transistors MOS à enrichissement (32, 34) du type à conductivité opposée à celle des premiers transistors, lesquels seconds transistors sont agencés respectivement entre un bus (12, 14) et l'autre pôle (11) de la tension d'alimentation, leurs grilles étant commandées par le signal de commande via un circuit d'inversion MOS.

4. Circuit intégré selon la revendication 3, caractérisé en ce que le circuit d'inversion (28) se présente sous la forme d'une porte CMOS inversante (40, 42, 44, 46) avec une entrée de commutation (17), l'amplificateur différentiel (16) présente une entrée de commutation (17) pour le mettre hors circuit et les deux entrées de commutation sont commandées par un signal de commutation commun (SE).

5. Circuit intégré selon la revendication 3 ou 4, caractérisé en ce que le montage à résistance est un troisième transistor MOS à enrichissement (26) de même type de conductivité que les seconds transistors (32, 34), dont le rapport de la largeur à la longueur est inférieur à celui des premiers transistors (22, 24), en ce qu'on monte en parallèle avec les premiers transistors (22, 24) un quatrième transistor MOS à enrichissement (48) de même type de conductivité que ces transistors et en ce que les grilles des troisième et quatrième transistors sont commandées par un signal de commutation du détecteur (CS).

6. Circuit intégré selon l'une quelconque des revendications 3 à 5, ayant une structure si restreinte qu'il peut apparaître au moins dans quelques transistors des électrons chauds, caractérisé en ce qu'entre au moins une partie des transistors (22, 24, 48; 26, 32, 34, 40, 44) connectés aux pôles (11, 13) de la tension d'alimentation et les sorties de signalisation de ces transistors, on agence respectivement un autre transistor (50; 52, 54, 56, 58) qui a respectivement le même type de conductivité et dont la grille est connectée à une prétension fixe (VR, VR1).
